# EUROPEAN PATENT APPLICATION

(11) **EP 4 633 016 A1**
(43) Date of publication of application: **15.10.2025**
(21) Application number: 22968926.0
(22) Date of filing: 22.12.2022
(51) Int. Cl.: H02M 1/00

(54) **HEAT DISSIPATION APPARATUS, ELECTRONIC DEVICE AND VEHICLE**

(71) Applicant: Shenzhen Yinwang Intelligent Technologies Co., Ltd., Shenzhen, Guangdong 518110 (CN)
(72) Inventor: PENG, Yaofeng, Shenzhen, Guangdong 518129 (CN); SHI, Jian, Shenzhen, Guangdong 518129 (CN)
(74) Representative: Maiwald GmbH
(86) International application number: PCT/CN2022/140952
(87) International publication number: WO 2024/130625

(57) **Abstract**

This application provides a heat dissipation apparatus, an electronic device, and a vehicle. The heat dissipation apparatus includes: a cover; a housing, including a first housing portion and a second housing portion, where the first housing portion and the second housing portion form a first cavity, the first cavity is used to accommodate a to-be-cooled apparatus, the to-be-cooled apparatus is fastened to a circuit board, the circuit board is fastened to the first housing portion by a spring screw, and the first housing portion includes a second cavity; a first heat dissipation structure, fastened to a bottom portion of the second cavity, where the first heat dissipation structure includes a plurality of first heat dissipation fins, a gap between adjacent fins in the plurality of first heat dissipation fins is less than or equal to a first value, and a thickness of the first heat dissipation fin is less than or equal to a second value; and a heat-conducting material layer, located between the first housing portion and the to-be-cooled apparatus, and configured to conduct heat from the to-be-cooled apparatus to the first heat dissipation structure, where a thickness of the heat-conducting material layer is less than or equal to a third value. The heat dissipation apparatus provided in this application can effectively improve heat dissipation effect.

## Description

### TECHNICAL FIELD

This application relates to the field of heat dissipation technologies for devices, and more specifically, to a heat dissipation apparatus, an electronic device, and a vehicle.

### BACKGROUND

With development of intelligent driving technologies, there is an increasingly high demand for a high-computing-power module inside a vehicle, and consequently, power consumption and generated heat of the high-computing-power module also increase rapidly. The heat, if not dissipated in a timely and effective manner, may affect application performance of the high-computing-power module, and more seriously, may affect reliability of the vehicle, causing a traffic accident.

A conventional heat dissipation design can be effective for heat dissipation from a low-computing-power module, but has poor heat dissipation effect on a high-computing-power module.

### SUMMARY

This application provides a heat dissipation apparatus, an electronic device, and a vehicle. The heat dissipation apparatus can effectively improve heat dissipation effect.

A first aspect provides a heat dissipation apparatus, including: a cover; a housing, including a first housing portion and a second housing portion, where the first housing portion and the second housing portion form a first cavity, the first cavity is used to accommodate a to-be-cooled apparatus, the to-be-cooled apparatus is fastened to a circuit board, the circuit board is fastened to the first housing portion by a spring screw, the first housing portion includes a second cavity, the cover is configured to cover the second cavity, and the first housing portion is formed through die casting; a first heat dissipation structure, fastened to a bottom portion of the second cavity, where the first heat dissipation structure includes a plurality of first heat dissipation fins, a gap between adjacent fins in the plurality of first heat dissipation fins is less than or equal to a first value, and a thickness of the first heat dissipation fin is less than or equal to a second value; and a heat-conducting material layer, located between the first housing portion and the to-be-cooled apparatus, and configured to conduct heat from the to-be-cooled apparatus to the first heat dissipation structure, where a thickness of the heat-conducting material layer is less than or equal to a third value.

In the heat dissipation apparatus provided in this application, the circuit board is fastened to the first housing portion by the spring screw, and the heat-conducting material layer with a small thickness is provided between the first housing portion and the to-be-cooled apparatus, so that the to-be-cooled apparatus and the first housing portion can be closely attached to each other, and a heat conduction capability of the heat-conducting material layer can be ensured, avoiding an impact on heat transfer from the to-be-cooled apparatus due to an excessively thick heat-conducting material layer or poor attachment. In addition, the first heat dissipation structure with a small fin gap and a small fin thickness is used, to increase a deployment density of fins in the first heat dissipation structure, so that a heat exchange area of the first heat dissipation structure can be increased. Based on this, the heat dissipation apparatus provided in this application can present good heat dissipation effect on the whole.

The first heat dissipation structure may be fastened to the bottom portion of the second cavity by integrated die casting or hybrid die casting. By the integrated die casting, an integrated structure of the first heat dissipation structure and the first housing portion is directly obtained by die casting. By the hybrid die casting, the first heat dissipation structure is first formed, the first housing portion is then die-cast together with the formed first heat dissipation structure, and in this case, the first heat dissipation structure may be of a structure with a higher density of fins.

With reference to the first aspect, in some implementations of the first aspect, the first value is 5 mm, the second value is 2 mm, and the third value is 0.3 mm.

In this application, the thickness of the fin used in the first heat dissipation structure is less than or equal to 2 mm, and the gap between adjacent fins is less than or equal to 5 mm, so that a high density of fins can be ensured, and a heat exchange area can be increased. In addition, the thickness of the heat-conducting material layer is less than or equal to 0.3 mm, so that an impact on heat transfer from the to-be-cooled apparatus due to an excessively thick heat-conducting material layer can be avoided.

With reference to the first aspect, in some implementations of the first aspect, the first heat dissipation structure includes an extruded heat sink or a skived fin heat sink.

The extruded heat sink or the skived fin heat sink has a high density of fins. In an actual operation, another heat sink with a high density of fins may be used, for example, a forged heat sink.

With reference to the first aspect, in some implementations of the first aspect, a bottom portion of a recess includes a plurality of grooves, and the plurality of first heat dissipation fins are fastened to the bottom portion of the recess based on the plurality of grooves.

In this application, a plurality of grooves may be provided on the bottom portion of the recess, and then the first heat dissipation fins may be fastened to the bottom portion of the recess based on the plurality of grooves. Compared with a manner in which a heat dissipation structure is obtained directly by integrated die casting, this application can provide more heat dissipation fins, thereby increasing a heat exchange area of the heat dissipation structure.

With reference to the first aspect, in some implementations of the first aspect, the first housing portion further includes a heat-conducting structure, a first surface of the heat-conducting structure is in contact with the heat-conducting material layer, and heat conductivity of the heat-conducting structure is greater than heat conductivity of the first heat dissipation structure.

It should be noted that a temperature of a local region that is in the first heat dissipation structure and that corresponds to the to-be-cooled apparatus is usually higher than that of another region, and heat may not be transferred to a heat dissipation fin in the another region due to an impact of heat transfer. In other words, the heat dissipation fin in the another region may not be effectively used, resulting in a small actual effective heat exchange area, affecting heat dissipation effect.

Based on this, in this application, the heat-conducting structure is provided on the first housing portion to diffuse heat transferred from the heat-conducting material layer to more heat dissipation fins, thereby increasing an effective heat exchange area.

With reference to the first aspect, in some implementations of the first aspect, the heat dissipation apparatus further includes a second heat dissipation structure, the second heat dissipation structure includes a plurality of second heat dissipation fins provided on the cover, and the plurality of second heat dissipation fins are accommodated in the second cavity when the cover covers the second cavity.

In this application, the second heat dissipation structure may be further provided on the cover to further increase a heat exchange area of the heat dissipation apparatus, so that heat dissipation effect of the heat dissipation apparatus can be further improved.

The second heat dissipation structure may be formed with the cover by integrated die casting, or may be fastened to the cover by hybrid die casting, welding, bonding, snap fitting, or the like. This is not limited.

In an actual operation, the first heat dissipation structure and the second heat dissipation structure may be provided flexibly. For example, only the first heat dissipation structure or the second heat dissipation structure may be provided, or both the first heat dissipation structure and the second heat dissipation structure may be provided.

The first housing portion may further include a heat-conducting structure, for example, a copper plate structure, to transfer heat generated by the to-be-cooled apparatus to the cover.

With reference to the first aspect, in some implementations of the first aspect, the heat dissipation apparatus further includes a heat spread structure, the heat spread structure and the first housing portion are formed integrally, and the heat spread structure is configured to uniformly transfer heat conducted by the heat-conducting material layer to the plurality of first heat dissipation fins.

In this application, the heat dissipation structure may be further provided with the heat spread structure to first spread heat transferred from the to-be-cooled structure and then transfer the heat to the first heat dissipation structure, so that heat generated by the to-be-cooled apparatus can be transferred to more heat dissipation fins, increasing an effective heat exchange area of the first heat dissipation structure.

With reference to the first aspect, in some implementations of the first aspect, the heat spread structure includes an aluminum structure and a third cavity, the third cavity is used to accommodate a refrigerant, and the refrigerant is prepared by using a refrigerant substance that is in a liquid state at room temperature and that has an evaporation temperature less than or equal to a preset value.

For example, the refrigerant may be prepared by using an ammonia gas, a fluorinated liquid, or another refrigerant substance with a low evaporation temperature.

The refrigerant may also be referred to as a working fluid. In an actual operation, effect of rapid heat exchange and rapid heat spreading can be achieved through phase change of the refrigerant. For example, a large amount of heat can be released through phase change of the refrigerant from a gas state to a liquid state, while a large amount of heat can be absorbed through phase change from a liquid state to a gas state.

In this application, when the to-be-cooled apparatus generates heat, the heat of the to-be-cooled apparatus is transferred through the heat-conducting material layer to the aluminum structure, and is then transferred through the aluminum structure to the refrigerant in the third cavity. The refrigerant rapidly absorbs heat and evaporates, and then vapor produced through the evaporation of the refrigerant rises and undergoes heat exchange with the first housing portion, so that heat is quickly and uniformly transferred to the first housing portion. The vapor liquefies after the heat exchange, that is, re-converted into a liquid refrigerant. The liquid refrigerant merges into the original refrigerant to enter a next round of heat exchange (that is, gasification-liquefaction).

A second aspect provides an electronic device, including: a to-be-cooled apparatus; and the heat dissipation apparatus according to the first aspect or any possible implementation of the first aspect, where the heat dissipation apparatus is configured to dissipate heat from the to-be-cooled apparatus; and the to-be-cooled apparatus includes a chip.

A third aspect provides a vehicle, including the heat dissipation apparatus according to the first aspect or any possible implementation of the first aspect, and/or including the electronic device according to the second aspect.

### BRIEF DESCRIPTION OF DRAWINGS

FIG. 1 is a diagram of a structure of a vehicle 100 according to an embodiment of this application;
FIG. 2 is a diagram of a structure of a heat dissipation apparatus 200 according to an embodiment of this application;
FIG. 3 is a diagram of a structure of a first heat dissipation structure 30 according to an embodiment of this application;
FIG. 4 is a diagram of a structure of another first heat dissipation structure 30 according to an embodiment of this application;
FIG. 5 is a diagram of a structure of still another first heat dissipation structure 30 according to an embodiment of this application;
FIG. 6 is a diagram of a structure of a heat-conducting structure 70 according to an embodiment of this application;
FIG. 7 is a diagram of a structure of a second heat dissipation structure 80 according to an embodiment of this application;
FIG. 8 is a diagram of a structure of a heat spread structure 90 according to an embodiment of this application;
FIG. 9 is a diagram of a structure of an aluminum structure 91 in an arrangement manner according to an embodiment of this application; and
FIG. 10 is a diagram of a structure of an aluminum structure 91 in another arrangement manner according to an embodiment of this application.

### DESCRIPTION OF EMBODIMENTS

The solutions of this application may be applied to a thermal device related to an intelligent driving device, an intelligent terminal, a smart home, an on-board embedded device, or another device, for example, may be applied to a thermal device related to a smartphone, a desktop computer, a notebook computer, a tablet computer, a wearable device, a robot, a vehicle, an on-board device, or the like.

The intelligent driving device may include a road transportation means, a water transportation means, an air transportation means, an industrial device, an agricultural device, an entertainment device, or the like. For example, the intelligent driving device may be a vehicle. The vehicle is a vehicle in a broad sense, and may be a transportation means (such as a commercial vehicle, a passenger vehicle, a motorcycle, a flight vehicle, or a train), an industrial vehicle (such as a pallet truck, a trailer, or a tractor), an engineering vehicle (such as an excavator, a bulldozer, or a crane), an agricultural device (such as a lawn mower or a harvester), a recreational device, a toy vehicle, or the like. A type of the vehicle is not specifically limited in this application. In another example, the intelligent driving device may be an airplane, a ship, or another transportation means.

The thermal device may be understood as a heat generation source. The thermal device may be a resistor, an inductor, a capacitor, a computing module, or the like. The resistor, the inductor, the capacitor, the computing module, or the like may be mounted on a circuit board. The circuit board may be, for example, a printed circuit board (printed circuit board, PCB). The computing module may be specifically a chip with computing and processing capabilities, or may be a set of a plurality of components such as a processor and a memory that are integrated in a PCB. The processor includes but is not limited to a central processing unit (central processing unit, CPU), a general-purpose processor, a digital signal processor (digital signal processor, DSP), an application-specific integrated circuit (application-specific integrated circuit, ASIC), a field-programmable gate array (field-programmable gate array, FPGA) or another programmable logic device, a discrete gate or a transistor logic device, a discrete hardware component, a graphics processing unit (graphics processing unit, GPU), and an artificial intelligence (artificial intelligence, AI) chip. The general-purpose processor may be a microprocessor or any conventional processor.

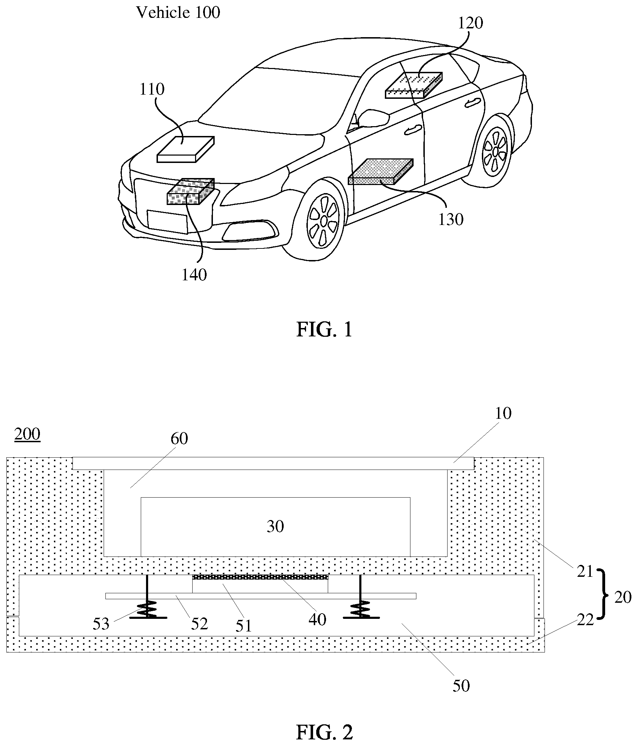

As shown in FIG. 1, a vehicle 100 is used as an example. The vehicle 100 may include one or more computing modules, such as a first computing module 110, a second computing module 120, a third computing module 130, and a fourth computing module 140. The one or more computing modules may be an on-board computing platform, for example, one or more of a mobile data center (mobile data center, MDC), a cockpit domain controller (cockpit domain controller, CDC), a vehicle running dynamic control system (vehicle running dynamic control system, VDC), a vehicle gateway module (vehicle gateway module, VGM), and the like. The one or more computing modules may be mounted on a center console or at an appropriate position near a liquid cooling pump or the like of the entire vehicle. An environment in which the vehicle is located is detected by using various sensors (such as a millimeter wave radar, a lidar, and a camera) mounted on the vehicle, and is then fed back to a chip or the like built in the computing module for real-time calculation. Finally, the computing module delivers an operation command to a vehicle control unit (vehicle control unit, VCU), and the VCU controls the motor vehicle (to brake, decelerate, or the like), implementing various levels of autonomous driving functions.

With development of intelligent driving technologies, an amount of data that needs to be processed by the computing module in the vehicle 100 is increasingly large, resulting in an increasingly high demand for computing power of the computing module. Consequently, power consumption and generated heat of the computing module also increase rapidly. Therefore, a proper heat dissipation design is required to dissipate heat generated by the computing module.

Therefore, this application provides a heat dissipation apparatus. The following describes in detail the heat dissipation apparatus provided in this application with reference to the accompanying drawings.

FIG. 2 is a diagram of a structure of a heat dissipation apparatus 200 according to an embodiment of this application. It should be understood that the heat dissipation apparatus 200 shown in FIG. 2 is merely an example. In an actual operation, the heat dissipation apparatus 200 may include more or fewer components, and a shape and a size of each component may be determined based on an actual situation. This is not limited.

As shown in FIG. 2, the heat dissipation apparatus 200 includes a cover 10, a housing 20, a first heat dissipation structure 30, and a heat-conducting material layer 40.

The housing 20 includes a first housing portion 21 and a second housing portion 22. The first housing portion 21 and the second housing portion 22 form a first cavity 50. The first cavity 50 is used to accommodate a to-be-cooled apparatus 51. The to-be-cooled apparatus 51 may be understood as the foregoing thermal device. The to-be-cooled apparatus 51 is fastened to a circuit board 52. The circuit board 52 may be fastened to the first housing portion 21 by a spring screw 53.

The first housing portion 21 includes a second cavity 60. The cover 10 is configured to cover the second cavity 60. The first heat dissipation structure 30 includes a plurality of first heat dissipation fins. The first heat dissipation structure 30 is fastened to a bottom portion of the second cavity 60. A gap between adjacent fins in the plurality of first heat dissipation fins is less than or equal to a first value, and a thickness of the first heat dissipation fin is less than or equal to a second value.

For example, the first value may be 5 mm. The gap between adjacent fins in the plurality of first heat dissipation fins may be, for example, 2 mm, 3 mm, 3 mm, or 5 mm. The second value may be 2 mm. The thickness of the first heat dissipation fin may be, for example, 1 mm or 2 mm.

In this application, the second cavity 60 may be understood as a channel of a cooling medium. When an air cooling technique is used for heat dissipation, the second cavity 60 may be understood as an air channel. When a liquid cooling technique is used for heat dissipation, the second cavity 60 may be understood as a liquid coolant channel.

The heat-conducting material layer 40 is located between the first housing portion 21 and the to-be-cooled apparatus 51. The heat-conducting material layer 40 is configured to conduct heat generated by the to-be-cooled apparatus 51 to the first heat dissipation structure 30, to dissipate the heat by using the plurality of first heat dissipation fins of the first heat dissipation structure 30.

A thickness of the heat-conducting material layer 40 is less than or equal to a third value. For example, the third value may be 0.3 mm. The thickness of the heat-conducting material layer 40 may be, for example, 0.1 mm, 0.2 mm, or 0.3 mm.

The heat-conducting material layer 40 may be prepared by using silicone grease, a thermally conductive phase-change film, an ultra-thin thermally conductive pad, or the like.

In the heat dissipation apparatus 200 provided in this application, the circuit board 52 is fastened to the first housing portion 21 by the spring screw 53, and the heat-conducting material layer 40 with a small thickness is provided between the first housing portion 21 and the to-be-cooled apparatus 51, so that the to-be-cooled apparatus 51 and the first housing portion 21 can be closely attached to each other, and a heat conduction capability of the heat-conducting material layer 40 can be ensured, avoiding an impact on heat transfer from the to-be-cooled apparatus 51 due to an excessively thick heat-conducting material layer 40 or poor attachment. In addition, the use of the first heat dissipation structure 30 with a small fin gap and a small fin thickness can increase a deployment density of fins in the first heat dissipation structure 30, so that a heat exchange area of the first heat dissipation structure 30 can be increased. Based on this, the heat dissipation apparatus 200 provided in this application can present good heat dissipation effect on the whole.

In an actual operation, the to-be-cooled apparatus 51 may be directly welded to the first housing portion 21 without the heat-conducting material layer 40, to implement close attachment. Alternatively, the circuit board 52 may be fastened to the first housing portion 21 by a common screw when the to-be-cooled apparatus 51 dissipates less heat, and in this case, the thickness of the heat-conducting material layer 40 may be greater than the third value. This is not limited in this application.

In this application, the first heat dissipation structure 30 may be fastened to the bottom portion of the second cavity 60 in the following three manners.

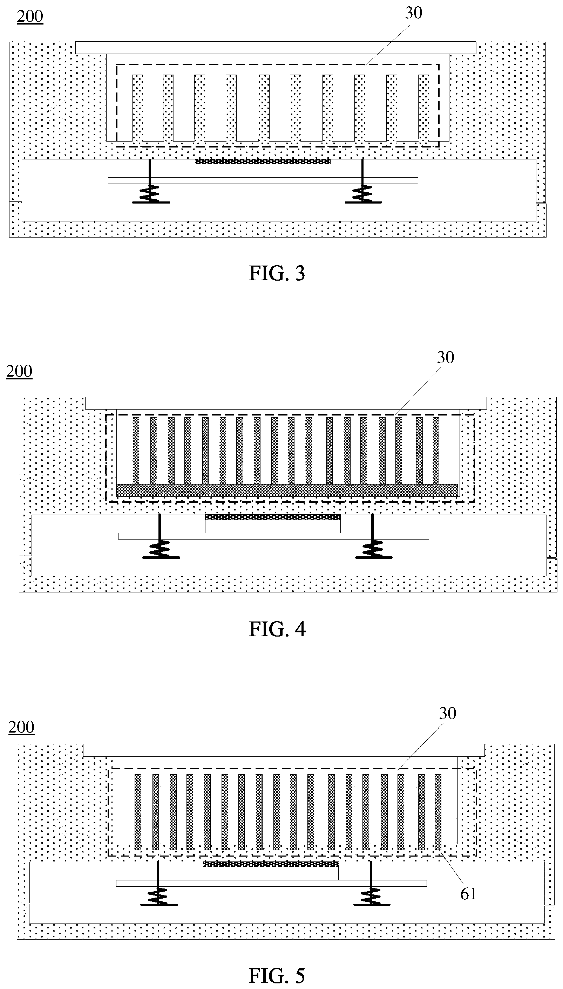

In an implementation, as shown in FIG. 3, the first heat dissipation structure 30 may be fastened to the bottom portion of the second cavity 60 by integrated die casting. By the integrated die casting, an integrated structure of the first heat dissipation structure 30 and the first housing portion 21 is directly obtained by die casting.

Due to a limitation of a die casting process, fins obtained by integrated die casting usually have a large fin thickness and a large fin gap. In this case, a quantity of fins that can be deployed is small, and a heat exchange area is small, resulting in low heat dissipation efficiency. Based on this, to further increase a heat exchange area of the first heat dissipation structure 30, this application provides the following two implementations.

In another implementation, as shown in FIG. 4, the first heat dissipation structure 30 may be fastened to the bottom portion of the second cavity 60 by hybrid die casting. By the hybrid die casting, the first heat dissipation structure 30 is first formed, and the first housing portion 21 is then die-cast together with the formed first heat dissipation structure 30.

In this implementation, a prepared heat sink with a high density of fins, such as an extruded heat sink, a skived fin heat sink, or a forged heat sink, may be used as the first heat dissipation structure 30, to increase a heat exchange area.

In still another implementation, as shown in FIG. 5, a plurality of grooves 61 may be provided on the bottom portion of the second cavity 60, and then a plurality of prepared heat dissipation fins are fastened to the bottom portion of the second cavity 60 based on the plurality of grooves 61. The plurality of heat dissipation fins may be in a flat and straight shape, or may be in a corrugated shape or a louver shape that can increase disturbance. This is not limited. Compared with the foregoing integrated die casting manner, this manner can provide more heat dissipation fins on the bottom portion of the second cavity 60, thereby increasing a heat exchange area.

It should be further noted that a temperature of a local region that is in the first heat dissipation structure 30 and that corresponds to the to-be-cooled apparatus 51 is usually higher than that of another region, and heat may not be transferred to a heat dissipation fin in the another region due to an impact of heat transfer. In other words, the heat dissipation fin in the another region may not be effectively used, resulting in a small actual effective heat exchange area, affecting heat dissipation effect.

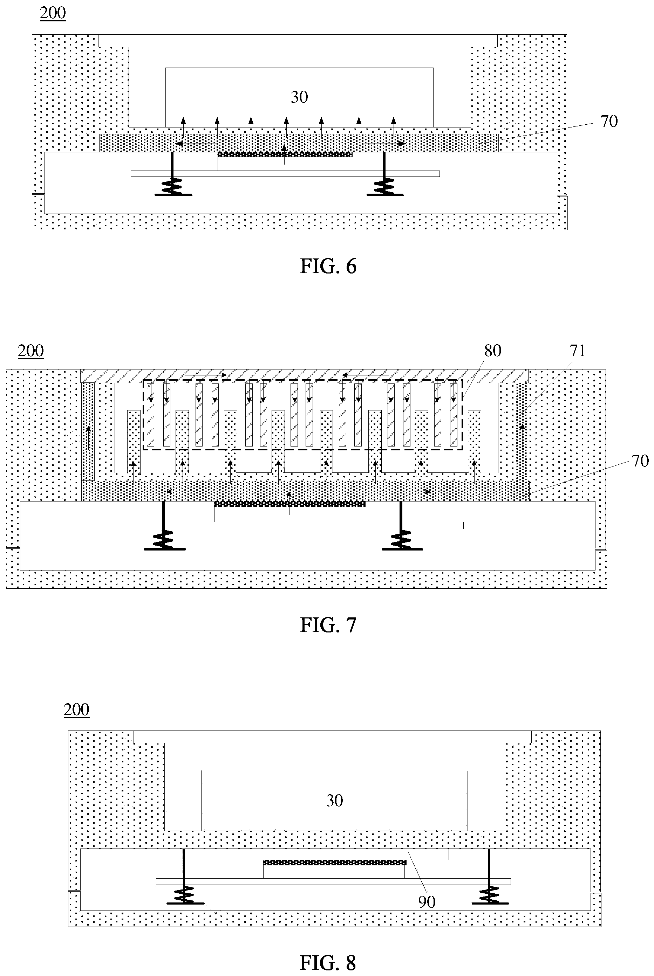

Based on this, in an implementation, as shown in FIG. 6, the first housing portion 21 may be provided with a heat-conducting structure 70. A first surface of the heat-conducting structure 70 is in contact with the heat-conducting material layer 40, and heat conductivity of the heat-conducting structure 70 is greater than heat conductivity of the first heat dissipation structure 30, so that heat transferred from the heat-conducting material layer 40 can be diffused to more heat dissipation fins in the first heat dissipation structure 30, thereby increasing an effective heat exchange area.

For example, the first housing portion 21 and the first heat dissipation structure 30 may be made of aluminum, and the heat-conducting structure 70 may be made of copper with higher heat conductivity.

For example, the heat-conducting structure 70 may be provided on the first housing portion 21 by hybrid die casting.

Based on this implementation, to further improve heat dissipation effect, as shown in FIG. 7, a second heat dissipation structure 80 may be further provided on the cover 10. The second heat dissipation structure 80 includes a plurality of second heat dissipation fins, to further increase a heat exchange area. When the cover 10 covers the second cavity 60, the plurality of second heat dissipation fins are accommodated in the second cavity 60.

In addition, to transfer heat generated by the to-be-cooled apparatus 51 to the second heat dissipation structure 80, the first housing portion 21 may be further provided with a heat-conducting structure 71. One end surface of the heat-conducting structure 71 is in contact with the heat-conducting structure 70, and the other end surface is in contact with the cover 10. The heat-conducting structure 71 may also be provided on the first housing portion 21 by hybrid die casting.

For example, the other end surface of the heat-conducting structure 71 may be fastened to the cover 10 by welding.

For example, the heat-conducting structure 71 may also be made of copper with higher heat conductivity.

The second heat dissipation structure 80 may be formed with the cover 10 by integrated die casting, or may be fastened to the cover 10 by hybrid die casting, welding, bonding, snap fitting, or the like. This is not limited.

The heat-conducting structure 70 and the heat-conducting structure 71 may be an integrated structure or may be separate structures. This is not limited.

In an actual operation, the first heat dissipation structure 30 and the second heat dissipation structure 80 may be provided flexibly. For example, in the heat dissipation apparatus 200, only the first heat dissipation structure 30 or the second heat dissipation structure 80 may be provided, or both the first heat dissipation structure 30 and the second heat dissipation structure 80 may be provided.

In another implementation, as shown in FIG. 8, a heat spread structure 90 may be further provided in the heat dissipation apparatus 200. The heat spread structure 90 may first spread heat conducted by the heat-conducting material layer 40 and then transfer the heat to the plurality of first heat dissipation fins of the first heat dissipation structure 30, so that heat generated by the to-be-cooled apparatus 51 can be transferred to more heat dissipation fins, increasing an effective heat exchange area of the first heat dissipation structure. The heat spread structure 90 and the first housing portion 21 may be formed through integrated die casting, or the heat spread structure 90 may be fastened to the first housing portion 21 by welding or hybrid die casting.

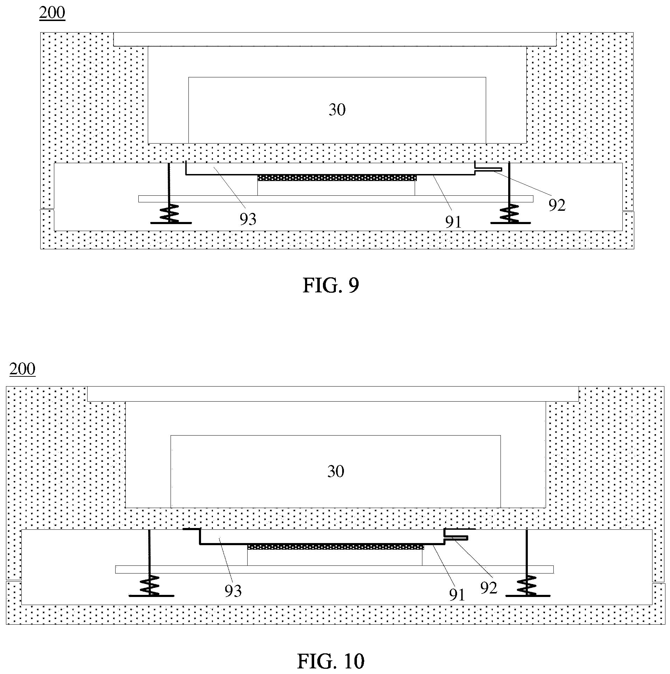

Optionally, as shown in FIG. 9 and FIG. 10, the heat spread structure 90 may include an aluminum structure 91 and a third cavity 93, the third cavity 93 is used to accommodate a refrigerant, and the refrigerant is prepared by using a refrigerant substance that is in a liquid state at room temperature and that has an evaporation temperature less than or equal to a preset value.

For example, the refrigerant may be prepared by using an ammonia gas, a fluorinated liquid, or another refrigerant substance with a low evaporation temperature (that is, a substance that is prone to phase change from a liquid state to a gas state).

When the first housing portion 21 is made of aluminum, the aluminum structure 91 and the first housing portion 21 may be directly formed through integrated die casting, as shown in FIG. 9. Alternatively, an aluminum plate may be first shaped to enclose a cavity (that is, the third cavity 93), and then formed together with the first housing portion 21 by hybrid die casting; or an aluminum plate may be first shaped to enclose a cavity, and then fastened to the first housing portion by welding (for example, friction stir welding), bonding, or another method, as shown in FIG. 10.

The heat spread structure 90 may further include a rat tail 92. In an actual operation, the refrigerant may be injected into the third cavity 93 through the rat tail 92, then the third cavity 93 is vacuumized, and then the rat tail 92 is sealed, to form a complete vapor chamber (vapor chamber, VC).

The refrigerant may also be referred to as a working fluid. In an actual operation, effect of rapid heat exchange and rapid heat spreading can be achieved through phase change of the refrigerant. For example, a large amount of heat can be released through phase change of the refrigerant from a gas state to a liquid state, while a large amount of heat can be absorbed through phase change from a liquid state to a gas state.

In this application, when the to-be-cooled apparatus 51 generates heat, the heat of the to-be-cooled apparatus 51 is transferred through the heat-conducting material layer 40 to the aluminum structure 91, and is then transferred through the aluminum structure 91 to the refrigerant in the third cavity 93. The refrigerant rapidly absorbs heat and evaporates, and then vapor produced through the evaporation of the refrigerant rises and undergoes heat exchange with the first housing portion 21, so that heat is quickly and uniformly transferred to the first housing portion 21. The vapor liquefies after the heat exchange, that is, re-converted into a liquid refrigerant. The liquid refrigerant merges into the original refrigerant to enter a next round of heat exchange (that is, gasification-liquefaction).

This application further provides an electronic device, including the to-be-cooled apparatus 51 and the heat dissipation apparatus 200. The heat dissipation apparatus 200 is configured to dissipate heat from the to-be-cooled apparatus 51. The to-be-cooled apparatus 51 may be a chip or another thermal device.

This application further provides a vehicle, including the heat dissipation apparatus 200 and/or including the electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A heat dissipation apparatus, comprising:
a cover;
a housing, comprising a first housing portion and a second housing portion, wherein the first housing portion and the second housing portion form a first cavity, the first cavity is used to accommodate a to-be-cooled apparatus, the to-be-cooled apparatus is fastened to a circuit board, the circuit board is fastened to the first housing portion by a spring screw, the first housing portion comprises a second cavity, the cover is configured to cover the second cavity, and the first housing portion is formed through die casting;
a first heat dissipation structure, fastened to a bottom portion of the second cavity, wherein the first heat dissipation structure comprises a plurality of first heat dissipation fins, a gap between adjacent fins in the plurality of first heat dissipation fins is less than or equal to a first value, and a thickness of the first heat dissipation fin is less than or equal to a second value; and
a heat-conducting material layer, located between the first housing portion and the to-be-cooled apparatus, and configured to conduct heat from the to-be-cooled apparatus to the first heat dissipation structure, wherein a thickness of the heat-conducting material layer is less than or equal to a third value.

2. The heat dissipation apparatus according to claim 1, wherein the first value is 5 mm, the second value is 2 mm, and the third value is 0.3 mm.

3. The heat dissipation apparatus according to claim 1 or 2, wherein the first heat dissipation structure comprises an extruded heat sink or a skived fin heat sink.

4. The heat dissipation apparatus according to any one of claims 1 to 3, wherein the first housing portion further comprises a heat-conducting structure, a first surface of the heat-conducting structure is in contact with the heat-conducting material layer, and heat conductivity of the heat-conducting structure is greater than heat conductivity of the first heat dissipation structure.

5. The heat dissipation apparatus according to claim 4, wherein the heat dissipation apparatus further comprises a second heat dissipation structure, the second heat dissipation structure comprises a plurality of second heat dissipation fins provided on the cover, and the plurality of second heat dissipation fins are accommodated in the second cavity when the cover covers the second cavity.

6. The heat dissipation apparatus according to any one of claims 1 to 5, wherein the heat dissipation apparatus further comprises a heat spread structure, the heat spread structure and the first housing portion are formed integrally, and the heat spread structure is configured to uniformly transfer heat conducted by the heat-conducting material layer to the plurality of first heat dissipation fins.

7. The heat dissipation apparatus according to claim 6, wherein the heat spread structure comprises an aluminum structure and a third cavity, the third cavity is used to accommodate a refrigerant, and the refrigerant is prepared by using a refrigerant substance that is in a liquid state at room temperature and that has an evaporation temperature less than or equal to a preset value.

8. The heat dissipation apparatus according to claim 7, wherein the refrigerant comprises an ammonia gas or a fluorinated liquid.

9. An electronic device, comprising:
a to-be-cooled apparatus; and
the heat dissipation apparatus according to any one of claims 1 to 8, wherein the heat dissipation apparatus is configured to dissipate heat from the to-be-cooled apparatus; and
the to-be-cooled apparatus comprises a chip.

10. A vehicle, comprising the heat dissipation apparatus according to any one of claims 1 to 8, and/or comprising the electronic device according to claim 9.
